# EUROPEAN PATENT APPLICATION

(11) **EP 4 039 471 A1**
(43) Date of publication of application: **10.08.2022**
(21) Application number: 20871323.0
(22) Date of filing: 16.09.2020
(51) Int. Cl.: B32B 27/20, H01L 23/36, H01L 23/373, C08K 7/00, C08L 101/00, C08J 5/18, B32B 7/027

(54) **THERMALLY CONDUCTIVE SHEET AND MANUFACTURING METHOD THEREOF**

(30) Priority: 30.09.2019 JP 2019179010
(71) Applicant: Sekisui Polymatech Co., Ltd., Saitama-city, Saitama 338-0837 (JP)
(72) Inventor: KUDOH, Hiroki, Saitama-city, Saitama 338-0837 (JP); ISHIHARA, Miho, Saitama-city, Saitama 338-0837 (JP)
(74) Representative: Ter Meer Steinmeister & Partner
(86) International application number: PCT/JP2020/035142
(87) International publication number: WO 2021/065522

(57) **Abstract**

A thermally conductive sheet comprising a scaly filler and a fibrous filler in a polymer matrix, wherein a long axis direction of a scale surface of the scaly filler and a fiber axis direction of the fibrous filler are oriented in the same direction, and a mass ratio of the scaly filler to the fibrous filler (scaly filler/fibrous filler) is 55/45 or more.

## Description

### Technical Field

The present invention relates to a thermally conductive sheet and a method for producing the same.

### Background Art

In electronic devices such as computers, automobile parts, and cellular phones, heat dissipating elements such as heat sinks are generally used to dissipate heat generated from heating elements such as semiconductor elements or mechanical parts. It is known that a thermally conductive sheet has been arranged between the heating element and the heat dissipating element for the purpose of increasing a heat transfer efficiency to the heat dissipating element.

The thermally conductive sheet generally comprises a polymer matrix and a thermally conductive filler dispersed in the polymer matrix. Further, the thermally conductive sheet may orient an anisotropic filler such as a thermally conductive fiber having an anisotropic shape in one direction in order to enhance the thermal conductivity in a specific direction.

As a thermally conductive sheet in which the anisotropic filler is oriented in one direction, for example, a thermally conductive sheet that orients a thermally conductive fiber in a certain direction by a magnetic field orientation applying a magnetic field line to a highly thermally conductive composition in which a thermally conductive fiber and a non-fibrous thermally conductive filler are dispersed in a polymer matrix., has been known (see, for example, PTL1).

### Citation List

### Patent Literature

PTL1: JP 2005-146057 A

### Summary of Invention

### Technical Problem

However, in recent years, an amount of heat generated by electronic devices has been increasing with the progress of their miniaturization and high performance, and a thermally conductive sheet having higher thermal conductivity than the thermally conductive sheet of PTL1 has been desired. Further, although the thermally conductive sheet as in PTL1 exhibits favorable thermal conductivity in the thickness direction thereof, it is unclear whether it can sufficiently cope with a high performance required in the future.

From the above, an object of the present invention is to provide a thermally conductive sheet having higher thermal conductivity.

### Solution to Problem

In the present invention, an attempt was made to further improve the thermal conductivity by containing a scaly filler and a fibrous filler in a polymer matrix, and orienting a long axis direction of a scale surface of the scaly filler and a fibrous axial direction of the fibrous filler in the same direction. However, containing the scaly filler increased the viscosity of the material, which may have rendered difficult the orientation in a magnetic field orientation as in PTL1. Therefore, the present inventors have found that the aforementioned problems can be solved by adopting a flow orientation as an orientation method and setting a content of the scaly filler within a predetermined range, and thus have completed the present invention.

Namely, the present invention provides the following [1] to [10].
[1] A thermally conductive sheet comprising a scaly filler and a fibrous filler in a polymer matrix, wherein a long axis direction of a scale surface of the scaly filler and a fiber axis direction of the fibrous filler are oriented in the same direction, and a mass ratio of the scaly filler to the fibrous filler (scaly filler/fibrous filler) is 55/45 or more.
[2] The thermally conductive sheet according to [1], wherein a mass ratio (scaly filler/fibrous filler) of the scaly filler to the fibrous filler is 65/35 to 95/5.
[3] The thermally conductive sheet according to [1] or [2], wherein when a thickness direction is a first direction, a direction perpendicular to the first direction is a second direction, and a direction perpendicular to the first direction and the second direction is a third direction, thermal conductivity of the first direction is 11 W/mK or more.
[4] The thermally conductive sheet according to any one of [1] to [3], wherein the scaly filler is scaly graphite powder.
[5] The thermally conductive sheet according to any one of [1] to [4], wherein the fibrous filler is carbon fiber.
[6] The thermally conductive sheet according to any one of [1] to [5], wherein each normal direction of a scale surface of the scaly filler is aligned in a predetermined direction.
[7] The thermally conductive sheet according to any one of [1] to [6], wherein the thermally conductive sheet is composed of a plurality of unit layers and each unit layer comprises the scaly filler and the fibrous filler and is laminated along one direction along a plane direction of the sheet.
[8] A method for producing a thermally conductive sheet comprising a scaly filler and a fibrous filler in a polymer matrix, comprising a mixture preparation step of preparing a mixture comprising a resin that is a precursor of the polymer matrix, the scaly filler, and the fibrous filler, and an orientation treatment step of orienting a long axis direction of a scale surface of the scaly filler and a fiber axial direction of the fibrous filler in the same direction by a flow orientation treatment when the mixture is formed into a predetermined shape.
[9] A method for producing a thermally conductive sheet comprising a scaly filler and a fibrous filler in a polymer matrix, comprising a mixture preparation step of preparing a mixture comprising a resin that is a precursor of the polymer matrix, the scaly filler, and the fibrous filler, an orientation treatment step of orienting a long axis direction of a scale surface of the scaly filler and a fiber axial direction of the fibrous filler in the same direction by a flow orientation treatment when the mixture is formed into a sheet shape, a step of preparing a plurality of primary sheets that underwent the orientation treatment step and laminating the plurality of primary sheets to form a laminated block, and a cutting step of cutting the laminated block into a sheet along a laminating direction.
[10] The method for producing the thermally conductive sheet according to [8] or [9], wherein a mass ratio (scaly filler/fibrous filler) of the scaly filler to the fibrous filler is 55/45 or more.

### Advantageous Effects of Invention

According to the present invention, a thermally conductive sheet having higher thermal conductivity can be provided.

### Brief Description of Drawings

[Fig. 1] Fig. 1 is a schematic perspective diagram illustrating the thermally conductive sheet according to an embodiment.
[Fig. 2] Fig. 2 is a schematic perspective diagram illustrating an example of the method for producing a thermal conductive sheet according to an embodiment.

### Description of Embodiments

Hereinafter, the thermally conductive sheet according to an embodiment of the present invention (the present embodiment) will be described in detail.

The thermally conductive sheet of the present embodiment contains a scaly filler and a fibrous filler in a polymer matrix, and a long axis direction of the scale surface of the scaly filler and a fibrous axial direction of the fibrous filler are oriented in the same direction. Being oriented in the same direction in this way enables the thermal conductivity in the thickness direction to be increased, for example, when the sheet is oriented in the thickness direction. Further, the presence of the scaly filler between one fibrous filler and another fibrous filler favorably forms a heat conduction path, which enables to obtain higher thermal conductivity.

By the way, a resin composition compounding the scaly filler together with the fibrous filler facilitates to increase a viscosity as compared with a resin composition with just the fibrous filler, or a resin composition compounding the fibrous filler and a spherical filler. Due to the high viscosity of such a resin composition, it is difficult to orient a long axis direction of the scale surface of the scaly filler and the fiber axial direction of the fibrous filler in the same direction by a magnetic field orientation. Therefore, in the present invention, a higher thermal conductivity has been successfully realized by adopting a flow orientation to orient the long axis direction of the scale surface of the scaly filler and the fiber axial direction of the fibrous filler in the same direction, and setting a mass ratio of the scaly filler to the fibrous filler (scaly filler/fibrous filler) to 55/45 or more.

Namely, when explaining the present embodiment from another aspect, the embodiment can be said to be a thermally conductive sheet containing the scaly filler and the fibrous filler in the polymer matrix, wherein by the flow orientation treatment, the long axis direction of the scale fiber of the scaly filler and the fiber axis direction of the fibrous filler are oriented in the same direction, and a mass ratio of the scaly filler to the fibrous filler (scaly filler/fibrous filler) is 55/45 or more.

Here, the "mass ratio of the scaly filler to the fibrous filler (scaly filler/fibrous filler) is 55/45 or more" means that the mass proportion of the scaly filler is equivalent to 55/45 or greater than that.

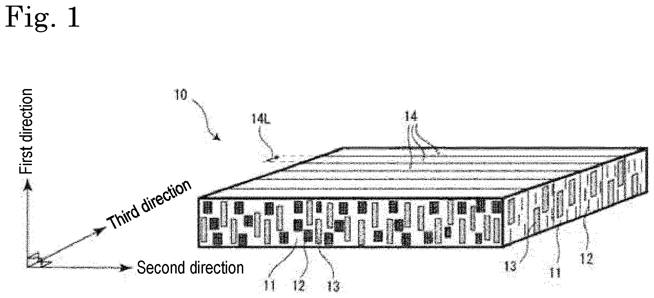

Fig. 1 shows an example of the thermally conductive sheet of the present embodiment. Thermally conductive sheet 10 of Fig. 1 contains a scaly filler 12 and a fibrous filler 13 in a polymer matrix 11, and a long axis direction of the scale surface of scaly filler 12 and a fiber axis direction of fibrous filler 13 are oriented in the same direction, specifically, in the thickness direction (first direction). Thermally conductive sheet 10 is, according to a production method thereof described below, composed of a plurality of unit layers 14, and each unit layer 14 contains scaly filler 12 and fibrous filler 13, and is laminated along one direction along the plane direction of sheet 10 (direction perpendicular to the first direction: a third direction).

Further, as shown in Fig. 1, when the thickness direction is the first direction, the direction perpendicular to the first direction is a second direction, and the direction perpendicular to the first direction and the second direction is a third direction, the first direction exhibits high thermal conductivity because the long axis direction of the scale surface of scaly filler 12 and the fiber axial direction of fibrous filler 13 are oriented in the same direction. Specifically, the thermal conductivity is preferably 8 W/mK or more, more preferably 11 W/mK or more, still more preferably 13 W/mK or more, and particularly preferably 16 W/mK or more. It is noted that the thermal conductivity is measured by the method based on ASTM D5470-06.

Moreover, for the second direction, it also exhibits high thermal conductivity because the short axis direction of the scale surface of scaly filler 12 and the fiber width direction of fibrous filler 13 are oriented in the same direction. Namely, the thermally conductive sheet shown in Fig. 1 is a two-directional thermally conductive sheet exhibiting high thermal conductivity in the first direction and the second direction.

Here, the thermal conductivity in the second direction is preferably 3 W/mK or more, more preferably 4 W/mK or more, and still more preferably 6 W/mK or more.

Hereinafter, each material constituting the thermally conductive sheet according to the present embodiment, etc., will be described.

### (Polymer matrix)

The polymer matrix is a member that holds the scaly filler, the fibrous filler, etc., and is preferably a soft rubbery elastic body. The polymer matrix is formed from a resin that is a precursor of the polymer matrix. In order for the scaly filler and the fibrous filler to be contained in the polymer matrix while being oriented, the resin is required to have fluidity when allowing the fibers to be oriented. For example, if the resin that is the precursor of the polymer matrix is thermoplastic resin, it can orient the scaly filler and the fibrous filler in a state of their being plasticized by heating. Moreover, if the resin that is a reactive liquid resin allows the scaly filler and the fibrous filler to be oriented before curing and then is cured while maintaining the state, a cured product in which the scaly filler and the fibrous filler are oriented can be obtained. The former has a relatively high viscosity, and if it is plasticized to a low viscosity, the resin may be thermally deteriorated, and thereby the latter resin is preferably adopted.

As the reactive liquid resin, rubber or gel that is liquid before a reaction and is cured under predetermined conditions to form a crosslinked structure, is preferred. The crosslinked structure is referred to as a structure such that at least a portion of the polymer is three-dimensionally crosslinked to form a cured product which is not melted by heating. Further, in order to fabricate a mixed composition in which the scaly filler and the fibrous filler are added to a liquid resin and to allow them to be oriented in the fluid liquid resin, the reactive liquid resin, preferably has a low viscosity and a property of being curable under predetermined conditions after curing.

As the curing method of such a reactive liquid resin, for example, a thermosetting and photocurable resin are exemplified, but since a large amount of scaly filler and fibrous filler that shield light is contained, thermosetting rubber or gel is preferably used. More specifically, a silicone resin, urethane rubber obtained by utilizing a reaction between a polyol and an isocyanate, acrylic rubber obtained by utilizing a radical reaction or a cationic reaction of acrylate, etc., can be exemplified, but the silicone resin is preferably used.

The silicone resin is not particularly limited as long as it is an organopolysiloxane, but a curable silicone resin is preferably used. In the case of a curable type, the silicone resin is obtained by curing a curable silicone composition. A silicone resin that is an addition reaction type may be used, or other silicone resin may be used. In the case of the addition reaction type, a curable silicone composition preferably comprises a silicone compound as a base resin and a curing agent that cures the base resin.

The silicone compound used as the base resin is preferably an alkenyl group-containing organopolysiloxane, and includes specifically vinyl group-containing organopolysiloxanes, such as a vinyl group-containing polydimethylsiloxane, a vinyl group-containing polyphenylmethylsiloxane, a vinyl group-containing dimethylsiloxane-diphenylsiloxane copolymer, a vinyl group-containing dimethylsiloxane-phenylmethylsiloxane copolymer, a vinyl group-containing dimethylsiloxane-diethylsiloxane copolymer.

The curing agent is not particularly limited as long as it can cure the silicone compound that is the aforementioned base resin, but organohydrogenpolysiloxane that is an organopolysiloxane having two or more hydrosilyl groups (SiH), is preferred.

The curing agent can adjust hardness of a primary sheet that will be described later by appropriately adjusting the number of hydrosilyl group and a molecular weight and a dosage ratio of the curing agent with respect to the base resin. Specifically, it can lower the hardness of the primary sheet by using a curing agent having a small number of hydrosilyl groups in one molecule or having a large molecular weight, or by reducing a dosage ratio of the curing agent to the base resin.

A content of the resin that is the precursor of the polymer matrix is preferably 15 to 50% by volume and more preferably 25 to 45% by volume in terms of % by volume (filling ratio) relative to the total amount of the thermally conductive sheet.

In thermally conductive sheet 10 shown in Fig. 1, adjacent unit layers 14 and 14 are adhered to each other, but preferably each unit layer 14 is directly adhered to the adjacent unit layer 14. Namely, preferably the adjacent unit layers 14 and 14 are directly adhered to each other not via a material other than the unit layer such as an adhesive. With such a configuration for each unit layer 14, for example, when the silicone resin is preferably used as a resin that is a precursor of a matrix, the silicone resins of each unit layer 14 are adhered to each other.

It is generally difficult for the silicone resins to be adhered to each other with high adhesion, but in the present embodiment, as will be described later, an adhesive surface of unit layer 14 is activated by VUV irradiation, and thereby the adjacent unit layers 14 and 14 are adhered to each other with relatively high adhesion. Therefore, no peeling occurs at an interface between unit layers 14. Further, since unit layers 14 and 14 are adhered to each other without other member interposed therebetween as well as without utilizing curing, etc., thermally conductive sheet 10 does not impair softness.

### (Scaly filler)

The scaly filler has an aspect ratio of preferably 3 or more, more preferably 6 to 50, and still more preferably 8 to 15 from the viewpoint of facilitating orientation in the thickness direction of the sheet to enhance thermal conductivity.

The aspect ratio refers to a ratio of a length in the long axis direction of the scale surface of the scaly filler and a thickness thereof.

Moreover, an average particle size (average long axis length) of the scaly fillers is preferably 10 to 400 µm and more preferably 15 to 300 µm. Further, it is particularly preferably 20 to 200 µm. By setting the average particle size to 10 µm or more, the fillers facilitate contact with each other in the thermally conductive sheet, which thereby ensures a heat transfer path, and renders favorable thermal conductivity of the thermally conductive sheet. When the average particle size is 400 µm or less, on the other hand, the bulk of the scaly filler is lowered, enabling high filling in the matrix.

It is noted that the average particle size of the scaly fillers can be calculated by observing them with a microscope and using the length in the long axis direction as a diameter. More specifically, the lengths in the long axis direction of 50 arbitrary scaly fillers are measured by using an electron microscope, an optical microscope, and an X-ray CT apparatus, and the average value (arithmetic mean value) thereof is calculated as an average particle size.

Moreover, a thickness of the scaly filler can also be measured by using an electron microscope, an optical microscope, and an X-ray CT apparatus in the same manner.

The scaly filler includes scaly carbon powder, scaly silicon carbide powder, scaly aluminum nitride powder, scaly boron nitride powder, scaly aluminum oxide powder, etc. Among them, scaly graphite powder is preferred.

The scaly graphite powder has graphite crystal planes connected in the in-plane direction of the scale plane and has high thermal conductivity in the in-plane direction. Therefore, aligning the scale surfaces in a predetermined direction enables thermal conductivity in a specific direction to be increased. The scale graphite powder preferably has a high degree of graphitization.

### (Fibrous filler)

The fibrous filler preferably has an aspect ratio of 4 or more, more preferably 7 to 100, and still more preferably 15 to 50 from the viewpoint of facilitating orientation of the fiber axis direction in the thickness direction of the sheet to enhance thermal conductivity.

The aspect ratio refers to a length (fiber length) of the fibrous filler in the fiber axis direction/a diameter of the fiber.

An average fiber length of the fibrous filler is preferably 20 to 500 µm and more preferably 80 to 400 µm. When the average fiber length is 20 µm or more, the fillers appropriately contact each other in the thermally conductive sheet to secure a heat transfer path and to have favorable thermal conductivity of the thermally conductive sheet. When the average fiber length is 500 µm or less, on the other hand, the bulk of the fibrous fillers is lowered, which enables high filling in the thermally conductive sheet. Moreover, even if a fibrous filler having conductivity is used, it prevents conductivity of the thermally conductive sheet from becoming unnecessarily high.

It is noted that the aforementioned average fiber length can be calculated by observing the fibrous filler with a microscope. For example, for fibrous fillers obtained by melting a matrix component of the thermally conductive sheet to separate the fillers, fiber lengths of 50 arbitrary fibrous fillers are measured by using an electron microscope or an optical microscope, and then an average value (arithmetic mean value) can be measured as the average fiber length. At this time, a large shear ought not to be applied so that the fiber is not crushed. Further if it is difficult to separate the fibrous fillers from the thermally conductive sheet, the fiber lengths of the fibrous filler may be measured by using an X-ray CT apparatus to calculate the average fiber length.

Moreover, a diameter of the fibrous filler can also be measured by using an electron microscope, an optical microscope, and an X-ray CT apparatus in the same manner.

It is noted that in the present invention, the arbitrary one means a randomly selected one.

The fibrous filler includes a carbon fiber, a metal fiber, a ceramics fiber, a polyparaphenylene benzoxazole fiber, etc. Among them, the carbon fiber is preferred.

The carbon fiber that is a graphitized carbon fiber is preferred. The graphitized carbon fiber has a crystal plane of graphite connected in the fiber axis direction and has high thermal conductivity in the fiber axis direction. Therefore, aligning the fiber axial direction in a predetermined direction enables thermal conductivity in a specific direction to be increased. The graphitized carbon fiber preferably has a high degree of graphitization.

A graphitized carbon material such as the graphitized carbon fiber described above can be used such that the following raw materials are graphitized. For example, condensed polycyclic hydrocarbon compounds such as naphthalene, condensed heterocyclic compounds such as PAN (polyacrylonitrile) and pitch are included, and graphitized mesophase pitch having a particularly high degree of graphitization, polyimide and polybenzazole are preferably used. For example, by using the mesophase pitch, in a spinning step described later, the pitch is oriented in the fiber axis direction due to its anisotropy, and a graphitized carbon fiber having excellent thermal conductivity in the fiber axis direction can be obtained.

A mode of use of the mesophase pitch in the graphitized carbon fiber is not particularly limited as long as it is spinnable, and the mesophase pitch may be used singly or combined with another raw material for use. However, the mesophase pitch being used singly, namely, a graphitized carbon fiber having a mesophase pitch content of 100% is most preferred from the viewpoint of high thermal conductivity, spinnability and stability of quality.

The graphitized carbon fiber obtained by carrying out each sequential treatment of spinning, infusibilization and carbonization, and then graphitizing after crushing or cutting to a predetermined particle size, or graphitizing after crushing or cutting after the carbonization may be used. When crushing or cutting before graphitization, a polycondensation reaction and cyclization reaction facilitates to proceed on a surface newly exposed by crushing upon the graphitization treatment, which thereby enhances the degree of graphitization to enable a graphitized carbon fiber with further improved thermal conductivity to be obtained. When spun carbon fibers are graphitized and then crushed, the carbon fibers after graphitization facilitates to be crushed due to its rigidity, and carbon fiber powder having a relatively narrow fiber length distribution can be obtained by crushing in a short time.

Here, the mass ratio of the scaly filler to the fibrous filler (scaly filler/fibrous filler) is, as described above, 55/45 or more, preferably 60/40 to 95/5, and more preferably 65/45 to 90/10. If the mass ratio is less than 55/45, the thermal conductivity in the thickness direction may not be sufficiently increased. Further, even when the normal directions of the scaly fillers are aligned, the thermal conductivity in the second direction will be lowered.

A total content of the scaly filler and the fibrous filler in the thermally conductive sheet is preferably 10 to 500 parts by mass and more preferably 50 to 350 parts by mass with respect to 100 parts by mass of the resin that is the precursor of the matrix. Moreover, the aforementioned total content is, when represented by a filling ratio based on volume (volume filling ratio), preferably 2 to 40% by volume and more preferably 8 to 30% by volume with respect to the total amount of the thermally conductive sheet.

The total content of 10 parts by mass or more facilitates to enhance the thermal conductivity, and the total content of 500 parts by mass or less facilitates to obtain an appropriate viscosity of a liquid composition described later, and then to enable favorable orientation of each filler.

The scaly filler and the fibrous filler are not particularly limited, but each generally has thermal conductivity of 30 W/m•K or more along a direction having anisotropy (i.e., the long axis direction and the fiber axis direction) and it preferably has 100 W/m•K or more. The upper limit of the thermal conductivity is not particularly limited, but is, for example, 2,000 W/m•K or less. A method for measuring thermal conductivity is a laser flash method.

Further, the scaly filler and the fibrous filler may have conductivity or an insulating property. When the scaly filler and the fibrous filler have the insulating property, they can enhance the insulating property in the thickness direction of the thermally conductive sheet, and thereby they can be suitably used in electrical equipment. Here in the present invention, having conductivity refers to, for example, a case where a volume resistivity is 1 × 10⁹Ω•cm or less. Further, having an insulating property refers to, for example, a case where the volume resistivity exceeds 1 × 10⁹Ω•cm.

The scaly filler and the fibrous filler may be each used singly or in combination of two or more. For example, scaly fillers or fibrous fillers including at least two fillers having average particle sizes or average fiber lengths that are different from each other, may be used. It is conjectured that if fillers of different sizes are used, small fillers can be penetrated between the relatively large fillers, which thereby enables filling of these fillers in the matrix at a high density as well as to enhance heat conduction efficiency.

In the example shown in Fig. 1, a scaly filler 12 and a fibrous filler 13 are oriented in the thickness direction (first direction) of the thermally conductive sheet in each unit layer 14. The orientation of scaly filler 12 and fibrous filler 13 in the thickness direction will be described more specifically. First, the scaly filler 12 is referred to as a filler being in a state of having a proportion of the number of the scaly fillers each in which an angle formed by the long axis direction of the scale surface of the scaly filler with respect to the thickness direction of the thermally conductive sheet 10 is less than 30°, exceeding 50% with respect to the total amount of the scaly fillers, and the proportion can be preferably more than 80%. In other words, the scaly filler 12 is referred to as a filler being in a state of having a proportion of the number of scaly fillers each in which an angle formed by the normal direction of the long axis direction of the scale surface with respect to the sheet surface of the thermally conductive sheet, is less than 30°, exceeding 50% with respect to the total amount of the scaly fillers, and the proportion preferably exceeds 80%.

Moreover, the fibrous filler 13 is referred to as a filler being in a state of having a proportion of the number of fibrous fillers each in which an angle formed by the long axis of the fibrous filler is less than 30° with respect to the thickness direction of thermally conductive sheet 10, exceeding 50% with respect to the total amount of the fibrous fillers, and the proportion preferably exceeds 80%.

Here, the orientation directions of scaly filler 12 and fibrous filler 13 each preferably has an angle formed by the fiber axial direction of the fibrous filler with respect to the thickness direction, or an angle formed by the long axis direction of the scale surface, of 0° or more and less than 5°, from the viewpoint of increasing the thermal conductivity. On the other hand, in terms of capable of reducing a load when having compressed thermally conductive sheet 10, it can be tilted in a range of 5° or more and less than 30°. It is noted that these angles are average values of the orientation angles of a fixed number of scaly fillers 12 or fibrous fillers 13 (for example, 50 arbitrary scaly fillers 12 or fibrous fillers 13).

Further, the scaly fillers are preferably fillers, the normal directions of the scale surfaces of which are aligned in a predetermined direction, and specifically, the scaly filler preferably faces the third direction shown in Fig. 1. In this way, the aforementioned two-directional thermally conductive sheet having satisfactory thermal conductivity in the first direction and the second direction, can be obtained. In order to obtain a two-directional thermally conductive sheet, a first method described in the production method below may be adopted.

### (Non-anisotropic filler)

In the present embodiment, a non-anisotropic filler other than the scaly filler and the fibrous filler may be contained in a matrix. The non-anisotropic filler is a material that imparts thermal conductivity to the thermally conductive sheet together with the scaly filler and the fibrous filler. By containing the non-anisotropic filler, the filler is interposed between the oriented scaly filler and fibrous filler, and a thermally conductive sheet having higher thermal conductivity can be obtained.

The non-anisotropic filler is a filler having substantially no anisotropy in shape, and is a filler that does not orient in a predetermined direction even under an environment where the scaly filler and the fibrous filler are oriented in the predetermined direction, such as under a shearing force action described below.

The non-anisotropic filler has an aspect ratio of less than 2 and more preferably 1.5 or less. The aspect ratio being less than 2 can prevent a viscosity of the liquid composition described below from being increased and achieve high filling.

The non-anisotropic filler may have conductivity, but preferably has an insulating property, and in the thermally conductive sheet, the scaly filler, the fibrous filler and the non-anisotropic filler preferably have the insulating property. When having the insulating property, they facilitate the insulating property in the thickness direction of the thermally conductive sheet to be further enhanced.

The non-anisotropic filler includes, for example, metals, metal oxides, metal nitrides, metal hydroxides, carbon materials, oxides other than metals, nitrides, carbides, etc. In addition, a shape of the non-anisotropic filler includes spherical or amorphous powder.

In the non-anisotropic filler, metals, such as aluminum, copper, nickel, metal oxides such as aluminum oxide represented by alumina, magnesium oxide and zinc oxide, and metal nitrides, such as aluminum nitride, etc., can be exemplified. The metal hydroxide includes aluminum hydroxide. Further, the carbon material includes spheroidal graphite. Oxides, nitrides and carbides other than metals include quartz, boron nitride, silicon carbide, etc.

Among them, aluminum oxide and aluminum are preferred in terms of high thermal conductivity and facilitation of availability of spherical aluminum compounds, and aluminum hydroxide is preferred in terms of facilitation of availability and capable of enhancing flame retardancy of the thermally conductive sheet.

Among the aforementioned fillers, a non-anisotropic filler having an insulating property includes, metal oxides, metal nitrides, metal hydroxides and metal carbides, but aluminum oxide and aluminum hydroxide are particularly preferred.

The non-anisotropic filler described above may be used singly, or two or more thereof may be combined for use.

An average particle size of the non-anisotropic filler is preferably 0.1 to 50 µm and more preferably 0.5 to 35 µm. Moreover, it is particularly preferably 1 to 15 µm. The average particle size of 50 µm or less hardly causes problems such as disturbing orientation of the scaly filler and the fibrous filler. Further, the average particle size of 0.1 µm or more allows a specific surface area of the non-anisotropic filler not to become larger than necessary, hardly increases a viscosity of the liquid composition even if a large amount thereof is compounded, and facilitates the non-anisotropic filler to be highly filled.

Here, the average particle size of the non-anisotropic filler can be measured by observing it with an electron microscope, etc. More specifically, particle sizes of 50 arbitrary non-anisotropic fillers are measured by using an electron microscope, an optical microscope, and an X-ray CT apparatus in the same manner as in measurement for the scaly filler and the fibrous filler, and the average value (arithmetic average value) can be used as an average particle size.

A content of the non-isotropic filler in the thermally conductive sheet is preferably in the range of 50 to 1,500 parts by mass and more preferably 200 to 800 parts by mass with respect to 100 parts by mass of a resin that is a precursor of a polymer matrix. When the content is 50 parts by mass or more, the amount of the non-anisotropic filler interposed in a gap between the scaly filler and the fibrous filler becomes a certain amount or more, giving favorable thermal conductivity. The content being 1,500 parts by mass or less, on the other hand, enhances an effect of increasing thermal conductivity depending on the content, and does not hinder thermal conduction by the scaly filler and the fibrous filler owing to the non-anisotropic filler. Further, when the content is in the range of 200 to 800 parts by mass, the thermal conductivity of the thermally conductive sheet becomes excellent, and the viscosity of the liquid composition also becomes suitable.

Here, the content of the non-anisotropic filler is, when represented by % by volume, preferably 10 to 75% by volume and more preferably 30 to 60% by volume, relative to the total amount of the thermally conductive sheet.

It is noted that each unit layer 14 in Fig. 1 has substantially the same composition. Therefore, the contents of the scaly filler, the fibrous filler, the non-anisotropic filler, and the resin that is the precursor of the polymer matrix, in each unit layer are the same as those in the thermally conductive sheet, and the contents of the scaly filler, the fibrous filler, the non-anisotropic filler, and the resin that is the precursor of the polymer matrix, in each unit layer are also those as described above.

### (Additional components)

In the thermally conductive sheet, various additives may be further compounded to the polymer matrix as long as a function as the thermally conductive sheet is not impaired. Examples of the additive include at least one selected from, for example, a dispersant, a coupling agent, an adhesive, a fire retardant, an antioxidant, a colorant, anti-settling additive, etc.

Moreover, when a curable silicone composition is cured, a curing catalyst, etc., that promote curing may be compounded as additives. The curing catalyst includes a platinum-based catalyst.

### (Other properties of thermally conductive sheet)

Type E hardness of the thermally conductive sheet is, for example, 70 or less. When the thermally conductive sheet has the type E hardness of 70 or less, softness is ensured, and for example, the followability to a heating element and a heat dissipating element becomes favorable, and the heat dissipation is apt to be favorable. From the viewpoint of improving the softness and rendering excellent followability, etc., the type E hardness of the thermally conductive sheet is preferably 40 or less. More preferably type 00 hardness thereof is 50 or less.

A lower limit of the hardness of the thermally conductive sheet is not particularly limited, but for example, it is 15 or more as the type 00 hardness, and preferably 25 or more. Moreover, it is particularly preferably 20 or more as the type E hardness. Preferably the softer the hardness of the thermally conductive sheet, the smaller a stress on the heating element, the heat dissipating element, or a substrate on which they are arranged when compressed. The hardness being 15 or more as the type 00 hardness can provide a thermally conductive sheet with a predetermined handleability. In particular, the hardness being 20 or more as the E hardness, can provide a sheet that is excellent in a balance between handleability and softness.

Here, the type E hardness and the type OO hardness are values measured by using a predetermined durometer according to the method specified in ASTM D2240-05.

In the present embodiment, at least one of the scaly filler and the fibrous filler is exposed on both surfaces of the thermally conductive sheet. Moreover, at least one of the exposed scaly filler and the fibrous filler may protrude from both surfaces. In the thermally conductive sheet, at least one of the scaly filler and the fibrous filler being exposed on both surfaces brings the exposed surface into a non-adhesive surface. Here, since both surfaces of the thermally conductive sheet become cut surfaces by cutting it with a cutting tool described below, at least one of the scaly filler and the fibrous filler is usually exposed on both surfaces.

However, one or both of both surfaces may be an adhesive surface without the scaly filler and the fibrous filler being exposed.

A thickness of the thermally conductive sheet is appropriately changed according to a shape and application of an electronic device on which the thermally conductive sheet is mounted. The thickness of the thermally conductive sheet is not particularly limited, but may be used in the range of, for example, 0.1 to 5 mm.

Moreover, a thickness of each unit layer is not particularly limited, but is preferably 0.1 to 5.0 mm and more preferably 0.3 to 3.0 mm. It is noted that the thickness of the unit layer is 14 L in length corresponding to that in the third direction in Fig. 1.

The thermally conductive sheet according to the present embodiment is used inside an electronic device, etc. Specifically, the thermally conductive sheet is interposed between the heating element and the heat dissipating element, conducts heat generated by the heating element to transfer the heat to the heat dissipating element, and dissipates the heat from the radiator. Here, examples of the heating element include various electronic components such as a CPU, a power amplifier, and a power supply, which are used inside the electronic device. Examples of the heat dissipating element include a heat sink, a heat pump, and a metal housing of the electronic device. The thermally conductive sheet keeps close contact in both surfaces with the heating element and the heat dissipating element, respectively, and is compressed for use.

### <Production method of thermally conductive sheet>

The method for producing the thermally conductive sheet of the present invention is a method for producing a thermally conductive sheet containing the scaly filler and the fibrous filler in the polymer matrix, comprising a mixture preparation step of preparing a mixture containing the resin that is the precursor of the polymer matrix, the scaly filler and the fibrous filler, and an orientation treatment step of allowing the long axis direction of the scale surface of the scaly filler and the fiber axis direction of the fibrous filler to be oriented in the same direction by a flow orientation treatment when forming the mixture into a predetermined shape. In the production method, since the flow orientation is employed to allow the long axis direction of the scale surface of the scaly filler and the fiber axial direction of the fibrous filler to be oriented in the same direction, a desired orientation state can be more definitely obtained than by a magnetic field orientation.

Here, the aforementioned "predetermined shape" is referred to as a specific shape such as a sheet shape or a columnar shape. Further, in order to obtain high thermal conductivity, the mass ratio of the scaly filler to the fibrous filler (scaly filler/fibrous filler) is preferably 55/45 or more.

A preferred aspect of the method for producing the thermally conductive sheet includes the following first to eighth methods.

### (First method)

The first method is a method for producing a thermally conductive sheet, comprising a step of, in the orientation treatment, allowing the long axis direction of the scale surface of the scaly filler and the fiber axis direction of the fibrous filler to be oriented in the same direction by the flow orientation treatment when forming the mixture into a sheet shape, preparing a plurality of primary sheets that underwent this orientation treatment step and laminating the plurality of primary sheets to form a laminated block, and a step of cutting the laminated block into sheets along the laminating direction.

### (Second method)

The second method is a method for producing a thermally conductive sheet, wherein forming the mixture into a platy shape while allowing the scaly filler and the fibrous filler to be oriented by subjecting the mixture to extrusion, injection molding, or press molding, winding up the formed plate around the orientation direction of the scaly filler and the fibrous filler, and surrounding the formed product thus obtained by an elastic body from the circumference, and thereafter cutting it along a plane perpendicular to the winding axis to form a platy thermally conductive sheet.

### (Third method)

The third method is a method for producing a thermally conductive sheet, wherein forming the mixture into a platy shape while allowing the scaly filler and the fibrous filler to be oriented by subjecting the mixture to extrusion, injection molding, or press molding, cutting the formed plate into a plurality of plates along the orientation direction of the scaly filler and the fibrous filler, laminating the plurality of plates after the cutting while aligning each aforementioned orientation direction, and surrounding the formed product thus obtained by an elastic body from the circumference, and thereafter cutting it along a plane perpendicular to the orientation direction to form a platy thermally conductive sheet.

### (Fourth method)

The fourth method is a method for producing a thermally conductive sheet, wherein when allowing the long axis direction of the scale surface of the scaly filler and the fiber axial direction of the fibrous filler to be oriented in the same direction by a flow orientation treatment upon forming the mixture into a sheet, allowing the mixture to pass through an orientation section and a compression section arranged in a forming die to form a thermally conductive sheet. Specifically, the method is a method for allowing it to pass through a die having a plurality of structures to carry out orientation forming. The mixture passing through a plurality of slits or circles provided in the die, or a flow path having a polygonal shape allows the scaly filler and the fibrous filler compounded in the mixture to be oriented into the thickness direction of the sheet, and subsequently, passing through the compression area arranged in the configured die to form a sheet without disturbing the orientation state of the inorganic particles having anisotropy, and then is extruded as a block from the die outlet. After curing the formed product by a method suitable for the resin, it is then cut in the width direction of the sheet thereby to produce a thermally conductive sheet.

### (Fifth method)

The fifth method is a method for first extruding the mixture by an extruder to form an elongated columnar temporary formed product in which the scaly filler and the fibrous filler are oriented along the extrusion direction, next aligning the plurality of the temporary formed products so as to become adjacent to each other in a direction orthogonal to the longitudinal direction, and then arranging the plurality of the aforementioned aligned temporary formed products as a layer in a direction substantially orthogonal to the aforementioned alignment direction to obtain a laminated body. By curing this laminated body, the final formed product in which the plurality of temporary formed products each constituting the laminated body are integrated with each other, is formed. The method for producing a thermally conductive sheet is a method for thereafter cutting the final formed product into a predetermined size in a direction orthogonal to the longitudinal direction of the aforementioned temporary formed product to obtain a thermally conductive sheet.

### (Sixth method)

The sixth method is a method for, first, applying a pressure to a mixture to fabricate a primary sheet in which the orientation direction of the scaly filler and the fibrous filler is substantially parallel to the main plane. The primary sheets are laminated to form a laminated body. The method for producing a thermally conductive sheet is a method for slicing the laminated body at an angle of 5 to 40° with respect to the normal line for the primary sheet plane of the laminated body to form a sheet, which is a thermally conductive sheet having a plane direction of the scaly filler tilted by 5 to 40° with respect to the surface of the thermally conductive sheet, or slicing the laminated body at an angle substantially perpendicular to the normal line for the primary sheet plane to form a sheet, and then subjecting the sliced sheet to roll press to form a thermally conductive sheet in which the plane direction of the scaly filler is tilted in a range of 5 to 40° with respect to the surface of the thermally conductive sheet.

### (Seventh method)

The seventh method is a method for producing a thermally conductive sheet in the following manner: First, a pressure is applied to a mixture to fabricate a primary sheet in which the orientation direction of the scaly filler and the fibrous filler is oriented in a direction substantially parallel to the main plane. This primary sheet is wound around the orientation direction of scaly graphite to form a laminated body. The laminated body is sliced at an angle of 5 to 40° with respect to the normal line for the primary sheet plane to form a sheet, which is a thermally conductive sheet in which the plane direction of the scaly graphite is tilted by 5 to 40° with respect to the surface of the thermally conductive sheet, or the laminated body is sliced at an angle substantially perpendicular to the normal line for the primary sheet plane to form a sheet, and then the sliced sheet is subjected to roll press to form a thermally conductive sheet in which the plane direction of the aforementioned scaly graphite is tilted in a range of 5 to 40° with respect to the surface of the thermally conductive sheet.

### (Eighth method)

The eighth method is a method for using a T-die having a first gap of a continuous vertical gap X and a second gap of a continuous vertical gap Y (where X < Y) to obtain a thermally conductive sheet in which the scaly filler and the fibrous filler are oriented in the thickness direction. Specifically, the eighth method is a method for producing a thermally conductive sheet, comprising a first step of allowing the mixture to pass through the first gap to obtain a resin formed precursor that was oriented to the plane direction of the scaly filler and the fibrous filler, and a second step of obtaining a resin formed product by fusing the resin formed precursor which has passed through the first gap while folding it in a direction substantially perpendicular to the extrusion direction. Here, the first gap is preferably 0.5 mm or more and 5.0 mm or less, and the second gap is preferably twice or more and 20 times or less the first gap.

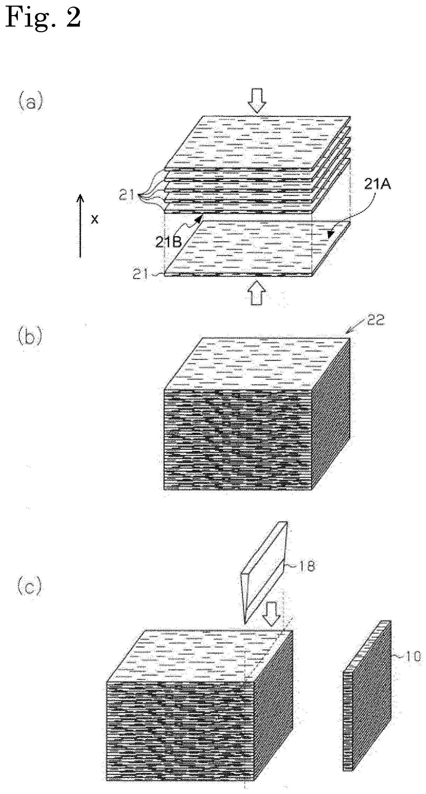

Among the aforementioned first to eighth methods, the first method is preferred, considering the fabrication of the thermally conductive sheet as shown in Fig. 1. The first method will be described with reference to Fig. 2.

### (Mixture preparation step, orientation treatment step)

First, a mixture (liquid composition) containing a resin (for example, a curable silicone composition) that is a precursor of a polymer matrix, the scaly filler and the fibrous filler, is prepared. The liquid composition is usually a slurry. The liquid composition may be further mixed with additional components if necessary. Here, mixing of each component constituting the liquid composition may be carried out by using, for example, a known kneader, a kneading roll, a mixer, or etc.

A viscosity of the liquid composition can be determined according to a sheet forming means and a desired sheet thickness. When the sheet forming is carried out by coating a base material with the liquid composition, the viscosity of the liquid composition is preferably 50 to 10,000 Pa•s. Setting the viscosity to 50 Pa•s or more and applying a shearing force facilitate the long axis direction of the scale surface of the scaly filler and the fiber axial direction of the fibrous filler to be oriented in the plane direction of the primary sheet. Further, the viscosity of 10,000 Pa•s or less enables favorable coatability.

Here, the viscosity is a viscosity measured at a rotation rate of 10 rpm by using a rotational viscometer (Brookfield viscometer DV-E, Spindle SC4-14), and the measured temperature is a temperature upon coating of the liquid composition.

For example, in the case of a curable silicone composition that is a liquid composition, it is usually liquid, and by appropriately adjusting a molecular weight, etc., of each component constituting the curable silicone composition (alkenyl group-containing organopolysiloxane, organohydrogenpolysiloxane, etc.), a viscosity may be adjusted to the aforementioned viscosity. Further, in the liquid composition an organic solvent may be compounded as needed in order to adjust the viscosity, but preferably the organic solvent is not compounded.

Next, forming of the liquid composition into a sheet while applying a shearing force, allows the long axis direction of the scale surface of the scaly filler and the fiber axial direction of the fibrous filler to be oriented in a direction parallel to the sheet surface (i.e., the plane direction). Here, a base material film is preferably coated with the liquid composition by, for example, a coating applicator such as a bar coater or a doctor blade, or by extrusion, ejection from a nozzle, etc., and such a method can impart a shear force along the coating direction of the liquid composition. Under this shearing force, the long axis direction of the scale surface of the scaly filler and the fiber axial direction of the fibrous filler, in the liquid composition are oriented in the coating direction.

### (Step of forming laminated blocks)

Next, the liquid composition formed into a sheet is cured to obtain a primary sheet. In the primary sheet, as described above, the long axis direction of the scale surface of the scaly filler and the fiber axis direction of the fibrous filler are oriented along the plane direction. Curing of the liquid composition is carried out by curing the curable silicone composition contained in the liquid composition. The liquid composition may be cured by heating, and for example, it may be carried out at a temperature of about 50 to 150°C. A heating time is, for example, about 10 minutes to 3 hours.

It is noted that in the case of compounding a solvent in the liquid composition, the solvent may be volatilized by heating upon curing.

A thickness of the primary sheet obtained by curing is preferably in the range of 0.1 to 5.0 mm. The thickness of the primary sheet within the above range, appropriately enables orientation of the scaly filler and the fibrous filler in the plane direction by the shear force. Further, the thickness of the primary sheet being 0.1 mm or more facilitates it to be peeled off from the base material film. Further, the thickness of the primary sheet being 5.0 mm or less prevents the primary sheet from being deformed by its own weight. From these viewpoints, the thickness of the primary sheet is more preferably 0.3 to 3.0 mm.

The type 00 hardness of the primary sheet is preferably 6 or more. When the hardness is 6 or more, the primary sheet does not spread so much even if a pressure is applied when laminating the primary sheet, and a laminated block having a sufficient thickness can be fabricated. From such a viewpoint, the type OO hardness of the primary sheet is more preferably 10 or more and still more preferably 15 or more.

Moreover, from the viewpoint of ensuring softness of the thermally conductive sheet obtained, the type E hardness of the primary sheet is preferably 70 or less and more preferably 40 or less. Further, the hardness is more preferably 50 or less as the type 00 hardness.

### (VUV irradiation step)

Here, VUV irradiation is preferably carried out for at least one surface of the cured primary sheet. VUV is a vacuum ultraviolet ray, and refers to an ultraviolet ray having a wavelength of 10 to 200 nm. Examples of the light source of the VUV include an excimer Xe lamp and an excimer ArF lamp.

The cured primary sheet contains the silicone resin (organopolysiloxane) as described above, and when VUV is irradiated, a surface irradiated with VUV is activated. As will be described later, the primary sheet is firmly adhered with each other by laminating it with another primary sheet so that one of the activated surfaces becomes an overlapping surface.

Although the principle is not clear, it is conjectured that when the silicone resin is irradiated with VUV, the C-Si bond of organopolysiloxane changes to Si-O bond such as Si-OH whereby the primary sheets are firmly adhered to each other. Namely, the primary sheet and the primary sheet (unit layers 14, 14) are adhered by forming of intermolecular bond of the organopolysiloxane.

The VUV irradiation conditions are not particularly limited as long as a surface of the primary sheet can be activated, but for example, VUV irradiation may be carried out so that an integrated irradiation amount is 5 to 100 mJ/cm² and preferably the integrated irradiation amount is 10 to 50 mJ/cm².

Next, as shown in Figs. 2(a) and 2(b), the plurality of primary sheets 21 are laminated so that the orientation directions of the long axis direction of the scale surface of the scaly filler and the fiber axis direction of the fibrous filler are the same. Here, as described above, each primary sheet 21 may have been previously irradiated with VUV on any one of the overlapping surfaces that are in contact with each other. By one surface irradiated with VUV, the adjacent primary sheets 21 and 21 are adhered to each other by the activated one surface. Further, from the viewpoint of further improving adhesiveness, both the overlapping surfaces are preferably irradiated with VUV.

Namely, as shown in Fig. 2 (a), primary sheet 21 may be overlapped so as to contact one surface 21A irradiated with VUV with another primary sheet 21, but in this case, preferably the other surface 21B of the other primary sheet 21 in contact with the one surface 21A is also irradiated with VUV.

Primary sheet 21 can be adhered only by overlapping as described above, but in order to adhere it more firmly, primary sheet 21 may be pressed in the laminating direction x. The pressurization may be carried out at a pressure such that primary sheet 21 is not significantly deformed, and can be carried out by using, for example, a roller or a press. As an example, when using a roller, the pressure is preferably 0.3 to 3 kgf/50 mm.

The laminated primary sheet 21 may be appropriately heated, for example, upon pressurization, etc., but primary sheet 21 activated by VUV irradiation can be adhered without heating, and thereby laminated primary sheet 21 is preferably not heated. Therefore, a temperature upon pressing is, for example, 0 to 50°C, and preferably about 10 to 40°C.

### (Cutting step)

Next, as shown in Fig. 2(c), a laminated block 22 is cut along the laminating direction x of primary sheet 21 by a cutting tool 18 to obtain a thermally conductive sheet 10. In this case, laminated block 22 may be cut in a direction orthogonal to the orientation direction of the long axis direction of the scale surface of the scaly filler and the fiber axial direction of the fibrous filler. As a blade 18, for example, a double-edged blade such as a razor blade or a cutter knife, a single-edged blade, a round blade, a wire blade, a saw blade, etc., can be used. Laminated block 22 is cut by a method such as push-cutting, shearing, rotation, sliding, etc., by using cutting tool 18.

Here in the production method described above, the example of having used the curable silicone composition that was cured by heating as a raw material of the silicone resin, has been described, but the raw material of the silicone resin is not limited to that having curability, and those having no curability may be used. In such a case, the liquid composition may be used such that a mixture of the silicone resin, the scaly filler, the fibrous filler, and other additive components as needed are compounded and diluted with an organic solvent. The liquid composition diluted with the organic solvent may be formed into a sheet and dried to form a primary sheet, and the primary sheet obtained by the drying may be irradiated with VUV.

In the above description, the aspect in which each unit layer in the thermally conductive sheet has substantially the same composition, has been described, but the composition of each unit layer may be different from each other.

Further, each unit layer does not necessarily have the same contents of the scaly filler and the fibrous filler, and a content of the scaly filler or the fibrous filler in some unit layers may be different from a content of the scaly filler or the fibrous filler in another unit layers. Further, a type of the scaly filler or the fibrous filler in some unit layers may be different from a type of the scaly filler or the fibrous filler in other unit layers.

As described above, by appropriately adjusting a content, type, etc., of the scaly filler and the fibrous filler in each unit layer, thermal conductivity of some unit layers may be allowed to be higher than thermal conductivity of other unit layers. In such a case, the unit layer having higher thermal conductivity and the unit layer having lower thermal conductivity may be arranged alternately, but may not necessarily be arranged alternately.

Similarly, conductivity of some unit layers may be lower than conductivity of other unit layers. In such a case as well, a unit layer having higher conductivity and a unit layer having lower conductivity may be arranged alternately, but may not necessarily arranged alternately. By lowering conductivity of some unit layers than those of other unit layers, conductivity along the third direction (see Fig. 1) is hindered due to some unit layers having the low conductivity. Therefore, even in the entire thermal conductive sheet, the conductivity in the third direction lowers, facilitating to secure an insulating property. In addition, in order to facilitate the insulating property to be secured, it is preferred to allow a unit layer having lower conductivity not to contain a thermally conductive filler.

Moreover, some of the plurality of unit layers may be unit layers having thermal conductivity, and some of another unit layers may be unit layers having light transmission. The unit layer having thermal conductivity is a layer containing the thermally conductive filler, preferably the scaly filler and the fibrous filler and the non-anisotropic filler as described above. On the other hand, the unit layer having light transmittance may be, for example, a layer that does not contain a thermally conductive filler. According to such a configuration, the entire thermally conductive sheet also has certain thermal conductivity and light transmission along the thickness direction. The unit layer having thermal conductivity and the unit layer having light transmission may be arranged alternately, but may not necessarily be arranged alternately.

Of course, a composition other than the conductive filler may be changed for each unit layer. For example, types of silicone resins of some unit layers may be changed to types of silicone resins of other unit layers. Further, presence or absence of additive components in some unit layers, types and amounts of additive components, etc., may be different from those of other unit layers.

For example, by rendering at least some of types or amounts of silicone resins of some unit layers and a type or amount of thermally conductive filler different from those of other unit layers, hardness (type 00 hardness) of some unit layers may be different from hardness of other unit layers.

### Examples

Hereinafter, the present invention will be described in more detail with reference to Examples, but the present invention is not limited to these Examples.

In the present Examples, a viscosity of the liquid composition (mixture) was measured by the following method, and thermal conductivity of the thermally conductive sheet was evaluated.

### [Measurement of viscosity of liquid composition (mixture)]

The viscosity of the liquid composition of each Example was measured with a viscometer (a rotational viscometer DV-E manufactured by Brookfield Asset Management) using a rotor of spindle SC4-14 at a rotation rate of 10 rpm and a measurement temperature of 25°C. The results are shown in Tables 1 and 2.

### [Thermal conductivity]

The thermal conductivity in the thickness direction (first direction in Fig. 1) of the thermally conductive sheet produced was measured by the method according to ASTM D5470-06. Moreover, the thermal conductivity in the second direction and the third direction in Fig. 1 was also measured by the method according to ASTM D5470-06. The results are shown in Tables 1 and 2.

Here, the thermal conductivity in the second direction is thermal conductivity measured with a test piece (thickness 2 mm) obtained by cutting the laminated block of each Example described below so that the second direction is the thickness direction. The thermal conductivity in the third direction is thermal conductivity obtained by measuring the primary sheet of each Example (corresponding to the primary sheet 21 in Fig. 2, thickness of 2 mm).

In addition, the level of thermal characteristics in the second direction as shown in Fig. 1 is denoted as a percentage. Specifically, it was calculated by the following equation (1) so that an equivalent to the level in the first direction is "100%" and an equivalent to the level in the third direction is "0%".

Thermal characteristics level in the second direction = (λ2-λ3) / (λ1-λ3) .... (1)
λ1: Thermal conductivity in the first direction
λ2: Thermal conductivity in the second direction
λ3: Thermal conductivity in the third direction

### [Example 1]

As a curable silicone composition, an alkenyl group-containing organopolysiloxane (base resin) and a hydrogen organopolysiloxane (curing agent) (total of 100 parts by mass, volume filling ratio of 40% by volume), and 71.5 parts by mass (volume filling ratio of 12% by volume) of scaly graphite powder (average long axis length of 80 µm, aspect ratio of 4 to 8, thermal conductivity of 400 W/m•K) as the scaly filler, 58.5 parts by mass (volume filling ratio of 10% by volume) of graphitized carbon fiber (average fiber length of 100 µm, aspect ratio of 10, thermal conductivity of 500 W/m•K) as the fibrous filler, and 400 parts by mass (volume filling ratio of 39% by volume) of aluminum oxide (spherical, average particle size of 3 µm, aspect ratio of 1.0), were mixed to obtain a slurry liquid composition (mixture). The viscosity of the liquid composition at 25°C was 245 Pa•s.

A base material film made of polyethylene terephthalate (PET) was coated with the liquid composition unidirectionally at 25°C by using a bar coater as a coating applicator. The long axis direction of the scale surface of the scaly filler and the fiber axis direction of the fibrous filler were oriented in the coating direction, and the short axis was oriented in the normal direction of the coating surface. Next, the coated liquid composition was heated at 120°C for 0.5 hours to cure the liquid composition and to obtain a primary sheet having a thickness of 2 mm.

By using a VUV irradiation apparatus (trade name: Excimer MINI, manufactured by Hamamatsu Photonics Co., Ltd.), for both surfaces of each of the obtained primary sheets, each surface of the primary sheet was irradiated with VUV in the air at room temperature (25°C) under the condition of an integrated irradiation intensity of 20 mJ/cm². Next, 100 primary sheets irradiated with VUV were laminated and pressed with a roller at a pressure of 1.6 kgf/50 mm in an environment of 25°C to obtain a laminated block. The laminated block obtained was sliced with a cutter blade parallel to the laminating direction and perpendicular to the long axis direction of the scale surface of the scaly filler and to the orientation direction of the fiber axis direction of the fibrous filler, to obtain a thermally conductive sheet having each layer thickness of 2 mm and a sheet thickness of 2 mm.

### (Examples 2 to 6 and 8, Comparative Examples 1 to 4)

The same procedure as in Example 1 was each carried out except that the formulation of the scaly filler and the fibrous filler was changed as shown in Tables 1 and 2. It is noted that in Example 8 and Comparative Example 4, scaly graphite powder having an average long axis length of 40 µm (aspect ratio of 3 to 6, thermal conductivity of 400 W/m•K) was used as the scaly filler.

In each of Examples 2 to 4, the viscosity of the liquid composition at 25°C was 267 Pa•s or more. Further, Examples 5 and 6, and Comparative Example 3 had higher viscosities than 600 Pa•s. More specifically, the samples could not empirically follow the rotor from the extent that it exceeded 600 Pa•s and the rotor ran idle, and thereby a proper viscosity could not be measured. Therefore, it was denoted as "> 600 Pa•s".

Further, each thermally conductive sheet obtained had a thickness of 2 mm, and the thickness of each unit layer was 2 mm.

### (Example 7)

The same procedure as in Example 1 was carried out except that the scaly carbon powder was changed to boron nitride powder (average long axis length of 40 µm, aspect ratio of 4 to 8, and thermal conductivity of 100 W/m•K). The obtained thermally conductive sheet had a thickness of 2 mm, and each unit layer was 2 mm in thickness. The filling ratio of the boron nitride powder was 51.4% by volume, the filling ratio of the graphitized carbon fiber was 27.3% by volume, the filling ratio of the silicone resin was 36% by volume, and the filling ratio of aluminum oxide was 36% by volume. It is noted that the boron nitride powder and the graphitized carbon fiber each had the normal direction of the scale surface that was oriented in the laminating direction. The viscosity of the liquid composition at 25°C was 325 Pa•s. The obtained thermally conductive sheet had a thickness of 2 mm, and each unit layer was 500 µm in thickness.

### (Comparative Example 5)

The same liquid composition as in Example 1 was poured into a block-shaped mold, and while vibrating the forming material in the mold, a magnetic field of 10 tesla was applied thereto in a magnetic field generator so that the graphitized carbon fiber and the scaly carbon powder were oriented in the vertical direction of the mold. Subsequently, the mold taken out from the magnetic field generator was heated at 90°C for 60 minutes to react and cure the alkenyl group-containing organopolysiloxane and the hydrogenorganopolysiloxane, and then the orientated block was taken out from the mold. Subsequently, the obtained oriented block was sliced perpendicularly to the orientation direction (first direction) with a cutter blade to obtain thermally conductive sheets having a thickness of 2 mm. Moreover, the test piece for measuring the thermal conductivity in the second direction was fabricated by slicing it in an arbitrary direction perpendicular to the first direction, and the test piece for measuring the thermal conductivity in the third direction was fabricated by slicing it along the cross section perpendicular to both the first direction and the second direction.

**[Table 1]**

| | | | Example 1 | Example 2 | Example 3 | Example 4 | Example 5 | Example 6 | Example 7 | Example 8 |
|---|---|---|---|---|---|---|---|---|---|---|
| Resin for polymer matrix | Silicone | | 100 | 100 | 100 | 100 | 100 | 100 | 100 | 100 |
| Scaly filler | Scale graphite (average long axis length 80 µm) | | 71.5 | 78 | 84.5 | 117 | 123.5 | 127.4 | | |
| | Scale graphite (average long axis length 40 µm) | | | | | | | | | 71.5 |
| | Boron nitride (average long axis length 40 µm) | | | | | | | | 180 | |
| Fibrous filler | Carbon fiber (average fiber length 100 µm) | | 58.5 | 52 | 45.5 | 13 | 6.5 | 2.6 | 60 | 58.5 |
| Scaly filler/fibrous filler (mass ratio) | | | 55/45 | 60/40 | 65/35 | 90/10 | 95/5 | 98/2 | 75/25 | 55/45 |
| Other Fillers | Aluminum oxide (average particle size 3 µm) | | 400 | 400 | 400 | 400 | 400 | 400 | 400 | 400 |
| Viscosity (Pa•s) | | | 245 | 267 | 296 | 548 | > 600 | > 600 | 325 | 221 |
| Evaluation | Thermal conductivity | First direction | 15.7 | 16.1 | 16.3 | 16.5 | 16.2 | 15.5 | 13.5 | 13.8 |
| | | Second direction | 6 | 6.5 | 7.2 | 10.5 | 11.4 | 12.6 | 4.5 | 3.5 |
| | | Third direction | 2 | 2 | 2 | 2 | 2 | 2 | 1.5 | 2 |
| | Thermal characteristics level of second direction (%) | | 29% | 32% | 36% | 59% | 66% | 79% | 25% | 13% |

**[Table 2]**

| | | | Comparative Example 1 | Comparative Example 2 | Comparative Example 3 | Comparative Example 4 | Comparative Example 5 |
|---|---|---|---|---|---|---|---|
| Resin for polymer matrix | Silicone | | 100 | 100 | 100 | 100 | 100 |
| Scaly filler | Scale graphite (average long axis length 80 µm) | | 58.5 | | 130 | | 71.5 |
| | Scale graphite (average long axis length 40 µm) | | | | | 130 | |
| | Boron nitride (average long axis length 40 µm) | | | | | | |
| Fibrous filler | Carbon fiber (average fiber length 100 µm) | | 71.5 | 130 | | | 58.5 |
| Scaly filler/fibrous filler (mass ratio) | | | 45/55 | 0/100 | 100/0 | 100/0 | 55/45 |
| Other Fillers | Aluminum oxide (average particle size 3 µm) | | 400 | 400 | 400 | 400 | 400 |
| Viscosity (Pa•s) | | | 209 | 38 | > 600 | 485 | 245 |
| Evaluation | Thermal conductivity | First direction | 14.8 | 12 | 15.3 | 12 | 10.2 |
| | | Second direction | 5 | 2 | 12.8 | 9.5 | 2.9 |
| | | Third direction | 2 | 2 | 2 | 1.8 | 2.8 |
| | Thermal characteristics level of second direction (%) | | 23% | 0% | 81% | 75% | 1% |

Comparing Examples 1 to 6 and Comparative Examples 1 to 3, each of Examples 1 to 6 in which the scaly filler/fibrous filler was used at a ratio of 55/45 or more, was found to have the thermal conductivity in the first direction that was higher than that of Comparative Example 2 or Comparative Example 3 in which the graphitized carbon fiber and the scaly graphite powder were not combined for use. Moreover, in particular, the scaly filler/fibrous filler rendered the excellent thermal conductivity in the range of 60/40 to 95/5, and the thermal conductivity was maximized in the range of 65/35 to 90/10.

Comparing the viscosities of Examples 1 to 6, Comparative Example 2 and Comparative Example 3, it was found that the larger the proportion of the scaly filler, the higher the viscosity. On the other hand, Examples 4 and 5 exhibiting the high viscosities also render the high thermal conductivity, and thereby the thermally conductive sheet produced by the flow orientation was found to enable orientation of the graphitized carbon fibers and scaly graphite powder even in the formulation giving the high viscosity.

Comparing the thermal conductivity in the second direction of Examples 1 to 6, Comparative Example 2 and Comparative Example 3, it was found that the larger the proportion of the scaly filler, the higher the thermal conductivity in the second direction.

Example 7 exhibited the thermal conductivity of 13.5 W/mK. For example, it was found to have better characteristics than Comparative Example 2 in which the fibrous filler was used singly, and that the thermal conductivity could be increased even when boron nitride was used.

Comparing Example 1 and Comparative Example 5, there found to be the large difference in the thermal conductivity in the first direction, although each composition had the same formulation. These samples each having the scaly filler/the fibrous filler of 55/45, exhibited the high viscosity of 245 Pa•s, from which the long axis direction of the scale surface of the scaly filler and the fiber axis direction of the fibrous filler appear not to have been sufficiently oriented by the magnetic field orientation.

### Reference Signs List

10 Thermally conductive sheet
11 Matrix
12 Scaly filler
13 Fibrous filler
14 Unit layer

## Claims

1. A thermally conductive sheet comprising a scaly filler and a fibrous filler in a polymer matrix, wherein
a long axis direction of a scale surface of the scaly filler and a fiber axis direction of the fibrous filler are oriented in the same direction, and
a mass ratio of the scaly filler to the fibrous filler (scaly filler/fibrous filler) is 55/45 or more.

2. The thermally conductive sheet according to claim 1, wherein a mass ratio (scaly filler/fibrous filler) of the scaly filler to the fibrous filler is 65/35 to 95/5.

3. The thermally conductive sheet according to claim 1 or 2, wherein when a thickness direction is a first direction, a direction perpendicular to the first direction is a second direction, and a direction perpendicular to the first direction and the second direction is a third direction, thermal conductivity of the first direction is 11 W/mK or more.

4. The thermally conductive sheet according to any one of claims 1 to 3, wherein the scaly filler is scaly graphite powder.

5. The thermally conductive sheet according to any one of claims 1 to 4, wherein the fibrous filler is carbon fiber.

6. The thermally conductive sheet according to any one of claims 1 to 5, wherein each normal direction of a scale surface of the scaly filler is aligned in a predetermined direction.

7. The thermally conductive sheet according to any one of claims 1 to 6, wherein the thermally conductive sheet is composed of a plurality of unit layers and each unit layer comprises the scaly filler and the fibrous filler and is laminated along one direction along a plane direction of the sheet.

8. A method for producing a thermally conductive sheet comprising a scaly filler and a fibrous filler in a polymer matrix, comprising
a mixture preparation step of preparing a mixture comprising a resin that is a precursor of the polymer matrix, the scaly filler, and the fibrous filler, and
an orientation treatment step of orienting a long axis direction of a scale surface of the scaly filler and a fiber axial direction of the fibrous filler in the same direction by a flow orientation treatment when the mixture is formed into a predetermined shape.

9. A method for producing a thermally conductive sheet comprising a scaly filler and a fibrous filler in a polymer matrix, comprising
a mixture preparation step of preparing a mixture comprising a resin that is a precursor of the polymer matrix, the scaly filler, and the fibrous filler,
an orientation treatment step of orienting a long axis direction of a scale surface of the scaly filler and a fiber axial direction of the fibrous filler in the same direction by a flow orientation treatment when the mixture is formed into a sheet,
a step of preparing a plurality of primary sheets that underwent the orientation treatment step and laminating the plurality of primary sheets to form a laminated block, and
a cutting step of cutting the laminated block into a sheet along a laminating direction.

10. The method for producing the thermally conductive sheet according to claim 8 or 9, wherein a mass ratio (scaly filler/fibrous filler) of the scaly filler to the fibrous filler is 55/45 or more.
